# FASCICULE DE BREVET EUROPEEN

(11) **EP 2 826 048 B1**
(45) Date de publication et mention de la délivrance du brevet: **11.05.2016**
(21) Numéro de dépôt: 13715321.9
(22) Date de dépôt: 15.03.2013
(51) Int. Cl.: G01R 29/20, G01R 31/06, H01F 7/16, H01F 7/127, H01F 41/06

(54) **ACTIONNEUR ÉLECTROMAGNÉTIQUE A IMPÉDANCE MAÎTRISÉE**
ELEKTROMAGNETISCHES STELLGLIED MIT GESTEUERTER IMPEDANZ
ELECTROMAGNETIC ACTUATOR HAVING CONTROLLED IMPEDANCE

(30) Priorité: 16.03.2012 FR 1252397
(43) Date de publication de la demande: 21.01.2015
(73) Titulaire: Hager-Electro SAS, 67210 Obernai (FR)
(72) Inventeur: DEZILLE, Edouard, F-67210 Obernai (FR); FRITSCH, Pascal, F-67120 Dachstein (FR); BOITEUX, Vincent, F-67000 Strasbourg (FR); VOIRPIN, Jean-Marc, F-67000 Strasbourg (FR)
(74) Mandataire: Nuss, Laurent
(86) Numéro de dépôt international: PCT/FR2013/050535
(87) Numéro de publication internationale: WO 2013/136019

(56) Documents cités:
- EP-A1- 0 301 935
- WO-A1-97/34309
- WO-A1-2009/018850
- WO-A1-2010/103219
- US-A1- 2005 071 098

## Description

La présente invention a trait à un actionneur électromagnétique du type relais différentiel, et concerne un procédé visant à maîtriser l'impédance de tels appareils au cours d'une fabrication industrielle, c'est-à-dire en série. L'actionneur de l'invention est un dispositif à haute sensibilité, utilisé notamment dans le domaine de la protection différentielle, lorsque celle-ci est envisagée indépendamment de la tension secteur.

Dans ce cadre, les actionneurs ou relais différentiels utilisés dans l'industrie ou le tertiaire sont de différents types pour pouvoir répondre aux normes en vigueur (produits différentiels de type A, AC, G, S etc). Or, ils sont géométriquement identiques, c'est à dire que les pièces les constituant sont les mêmes, à l'exception de la bobine, dont le nombre de spire et la section du fil sont adaptés à chaque type de relais mentionné ci-dessus.

Ce type d'actionneur électromagnétique comprend en fait classiquement les composants suivants :
- une armature magnétique fixe, en général en forme de U, dont les extrémités des deux jambages constituent deux surfaces polaires coplanaires ;
- une palette en matériau magnétique apte à pivoter entre deux positions respectivement à distance, c'est à dire laissant subsister un espace avec l'armature et, en position armée du déclencheur, au contact desdites surfaces polaires, fermant ainsi le circuit magnétique constitué par ladite armature et ladite palette, le point de rotation de la palette se situant au voisinage immédiat de l'extrémité de l'un des jambages de l'armature ;
- un aimant permanent de polarisation du circuit magnétique, disposé entre les jambages de l'armature et créant une force magnétique permanente d'attraction de la palette vers les surfaces polaires, force magnétique qui s'exerce à l'encontre de la force de rappel d'un ressort ;
- une bobine d'induction entourant le circuit magnétique, reliée par exemple à un circuit à contrôler, en vue de modifier l'équilibre initial entre la force magnétique et la force de rappel du ressort.

Un tel actionneur est connu du document WO 2010/103219.

Le principe de fonctionnement, bien connu, est le suivant : lorsque par exemple un incident d'ordre différentiel survient dans des lignes protégées par le dispositif différentiel, induisant un courant dans le fil de la bobine, le flux créé à cette occasion dans le circuit magnétique de l'actionneur par la bobine se combine au flux généré par l'aimant permanent. La combinaison des flux induits par l'aimant d'une part, et par le courant apparu dans la bobine d'autre part, détruit l'équilibre mécanique initial et fait pivoter la palette, qui se déplace par rapport à l'armature. Le déplacement de la palette entraîne celui d'un organe mécanique, par exemple une tige, apte à déverrouiller la serrure d'un produit différentiel placé à proximité de l'actionneur électromagnétique, de telle sorte que ladite tige puisse agir sur un déclencheur.

Bien que les composants constituant le relais sont en principe les mêmes pour la fabrication en série du même modèle d'actionneur, on observe en pratique des variations d'impédances d'un relais à l'autre, principalement dues aux fluctuations des caractéristiques magnétiques de la matière et des variations de l'entrefer, qui sont de l'ordre du µm. La maîtrise de ces variations dans un process industriel est un problème récurrent et majeur.

Pour éviter autant que possible ce problème, on peut être tenté d'agir sur le tore qui leur est associé dans le cadre de la protection différentielle, tore qui réalise en pratique la fonction mesure, c'est-à-dire qu'il mesure le déséquilibre de courant dans le circuit protégé, dont les fils le traversent, constituant en fait le primaire d'un transformateur dont le secondaire est un fil bobiné autour du tore et relié à la bobine d'induction de l'actionneur. Un déséquilibre au primaire se retrouve bien entendu au secondaire, induisant un courant qui se retrouve dans la bobine d'induction de l'actionneur.

Une solution serait en effet par exemple d'associer aux relais un tore de volume plus important, dès lors plus onéreux, avec une conséquence économique sur le prix de revient global évidemment défavorable.

Pour remédier à ce problème, plutôt que d'utiliser un tel tore, une autre solution industriellement possible et souvent choisie actuellement consiste à effectuer un tri systématique des relais produits selon leur impédance. En pratique, après sa fabrication, chaque relais est contrôlé puis est classé suivant son impédance en plusieurs classes. Chacune de ces classes d'impédance est associée à un tore particulier qui n'est pas surdimensionné par rapport à l'actionneur avec lequel il fonctionne. La réalisation d'un tel tri s'avère économiquement plus intéressante que le choix d'un tore de plus gros volume.

Il n'y a donc pas, dans la manière actuelle de procéder industriellement, de traitement qui porte directement sur la variation de l'impédance des relais ou actionneurs produits, mais une prise en compte de ce qui sort effectivement des lignes de production, puis un tri sélectif.

Une solution bien connue pour agir directement sur l'impédance consisterait en un réglage de ladite impédance par l'aimant, le réglage de la puissance se faisant alors par le ressort monté sur une vis. L'inconvénient de cette solution est qu'un tel réglage doit être réalisé une fois le produit différentiel assemblé, et que le réglage par le ressort est long et difficile à mettre en place en production, ce qui rend cette solution industriellement inadéquate.

Selon une autre approche, la bobine peut permettre de faire varier assez simplement l'impédance du relais, qui devient différente d'un type de relais à l'autre si les bobines sont distinctes en termes de nombre de spires. Pour limiter les variations d'impédance des relais, l'idée à la base de l'invention est donc de bobiner un nombre de spires qui permette d'atteindre, avec un écart réduit, une impédance donnée.

On pourrait par exemple bobiner dans tous les cas un certain nombre de spires dont on sait que cela représente un surplus de spires par rapport résultat attendu, puis débobiner le nombre exact de spires pour atteindre l'impédance voulue. Ou encore faire l'inverse avec le bobinage initial d'un nombre de spires manifestement sous-estimé, suivi du bobinage d'un nombre de spires additionnel aboutissant à l'impédance recherchée.

Le résultat serait correct, précis, mais la mise en oeuvre impose des temps de cycle très importants, pas réellement compatible avec une fabrication industrielle en grande série.

Le problème est clairement de combiner l'idée de travailler sur le nombre de spires avec les exigences liées à une industrialisation des relais.

C'est ce que se propose de réaliser le procédé de fabrication de l'invention, qui vise par conséquent essentiellement à limiter les variations d'impédance au cours de la fabrication industrielle, et se caractérise à titre principal par les étapes suivantes :
a/ fermeture et maintien de la palette au contact de l'armature ;
b/ montage d'une ou deux bobines autour de l'armature ;
c/ envoi d'au moins un signal de courant I dans la ou les bobines ;
d/ mesure de la tension U aux bornes de la ou de l'une des bobines;
e/ mesure du courant I dans la ou l'autre des bobines ;
f/ calcul de l'impédance Zcal = U/I ;
g/ détermination du nombre de spires à bobiner en utilisant un abaque de bobinage représentant Nspires = f(Zcal).

En d'autres termes, lorsque le circuit magnétique du produit en cours de fabrication est fermé, on y bobine une ou deux bobines, on mesure dans la ou les bobines la tension aux bornes et le courant, on en déduit l'impédance, qui est par conséquent une impédance calculée, et on se sert d'une abaque pré-réalisée pour obtenir finalement le nombre de spires à bobiner en fonction de l'impédance telle que calculée.

Cette manière de procéder est beaucoup plus rapide que celle qui a été mentionnée auparavant et elle est également précise, suffisamment pour valider la pertinence industrielle du procédé.

Plus précisément, le procédé de l'invention peut comporter la génération et l'utilisation d'une première abaque représentant Zreel = f1(Zca1) pour un nombre prédéterminé d'actionneurs munis d'une succession de bobines ayant une pluralité prédéterminée de valeurs de nombres de spires, puis par la génération et l'utilisation d'une seconde abaque représentant Nspires = f2(Zreel) pour un nombre prédéterminé d'actionneurs munis d'une succession de bobines ayant une pluralité prédéterminée de valeurs de nombres de spires, et le croisement des deux abaques précédentes pour générer l'abaque de bobinage.

Pour l'obtention de la première abaque, on réalise en réalité des mesures systématiques des impédances réelles de plusieurs centaines d'actionneurs auxquels on a bobiné successivement des bobines de plusieurs centaines de spires à partir d'une valeur basse prédéterminée incrémentée d'un nombre de spires de l'ordre d'une dizaine ou d'un multiple d'une dizaine à chaque fois, et pour un nombre prédéterminé de fois. Alternativement, la valeur initiale du nombre de spires bobinées peut être une valeur haute qui est alors décrémentées d'un nombre de spires de l'ordre d'une dizaine ou d'un multiple d'une dizaine à chaque fois. Pour chaque actionneur on calcule par ailleurs l'impédance. L'ensemble des résultats obtenus permet de représenter l'abaque, qui est en pratique un nuage de points situés entre deux courbes enveloppe.

En ce qui concerne la seconde abaque, le nombre de spires est par exemple mis en ordonnée, et l'impédance réelle en abscisse. C'est donc l'impédance réelle qui est le trait d'union entre les deux abaques mentionnées ci-dessus, qui permettent d'en déduire l'abaque finale de bobinage représentant Nspires = f(Zca1), et combinant les deux premières.

Pour pouvoir effectuer les différentes mesures en situation réelle, la palette est fermée et maintenue en position fermée soit par action mécanique sur l'organe d'actionnement, lequel répercute l'action à la palette et la plaque contre l'armature, soit par passage d'un courant continu dans la bobine d'induction, le flux continu ainsi généré aboutissant à attirer la palette au contact de l'armature magnétique, soit par magnétisation de l'aimant qui engendre un flux magnétique apte à maintenir le relais en position fermé.

Pour effectuer les calculs d'impédance, nécessitant des mesures de tension U aux bornes d'au moins une bobine et de courant dans la ou lesdites bobines, plusieurs solutions sont possibles, modifiant quelque peu la mise en oeuvre du procédé de l'invention. Le calcul peut ainsi être basé sur deux bobines, respectivement de n spires et d'une spire, qui sont enroulées autour de zones adjacentes l'armature.

Alternativement, une unique bobine de n spires peut être montée autour de l'armature, n pouvant alors être égal à un nombre qui revient à utiliser une sorte de bobine « fictive » non réaliste pour une utilisation réelle, à des fins de mesure, par exemple comportant 5 spires. C'est ce même nombre « fictif » qui peut être utilisé lorsque deux bobines sont mises en oeuvre. Alternativement, le nombre n peut être bien plus élevé et représenter un bobinage réel, c'est-à-dire avec un nombre de spires réaliste pour un actionneur.

De même, le courant utilisé peut prendre différentes formes, selon l'état d'aimantation de l'aimant permanent, le moyen utilisé pour fermer et maintenir fermé la palette au contact de l'armature etc.

Ainsi, le signal de courant envoyé dans la bobine peut être d'allure sinusoïdale, ou constitué d'une composante continue et d'une composante d'allure sinusoïdale. De même, lorsqu'il y a deux bobines, il peut encore s'agir de deux signaux de courant constitués dans les deux cas d'une composante continue et d'une composante sinusoïdale.

Lors de la mesure de l'impédance, il y a une variabilité supplémentaire liée à la résistance de la bobine, qui rend la mesure moins précise lorsqu'il n'y a qu'une seule bobine, quelque soit le nombre de ses spires. En revanche, lorsqu'il y a deux bobines, la mesure de la tension U est effectuée aux bornes de la bobine à quelques spires (n) et la mesure du courant I s'effectue dans la bobine à une spire, ce qui diminue notablement l'imprécision dans la mesure du courant.

En bref, si la variabilité constatée est faible, on peut n'utiliser qu'une seule bobine, alors que si elle excède un seuil prédéterminé, il est préférable d'en utiliser deux, pour s'en affranchir.

Pour que le procédé de l'invention ait une efficacité accrue, sur un plan industriel, l'actionneur comporte un boîtier permettant à la bobine d'induction d'être bobinée hors du boîtier autour d'une branche de l'armature, lorsque ledit boîtier est refermé sur tous les autres composants. Dans cette hypothèse, le bobinage exact peut intervenir au dernier moment, dans la chaîne de fabrication, sur des boîtier déjà pré-équipés, sur lesquels il ne reste plus qu'à bobiner un nombre de spires donné par le procédé de l'invention, qui garantit une variabilité minimale de l'impédance pour des produits identiques ou presque (à l'exception du nombre de spires des bobines).

L'impédance d'un tel actionneur est notamment fonction de l'aimant permanent qui l'équipe, outre qu'elle dépend de l'entrefer et du matériau du circuit magnétique. Si les variations d'impédances dues à l'aimant permanent sont trop fortes, l'actionneur peut, dans le cadre du procédé de l'invention, être disposé entre des bobines de Helmholtz pendant la réalisation des étapes a/ à g/ telles que décrites auparavant.

L'impédance, même si elle est très majoritairement fonction de l'entrefer et du matériau du circuit magnétique, dépend aussi de l'aimant, et en particulier de son degré d'aimantation.

## Revendications

1. Procédé de limitation des variations d'impédance d'un actionneur électromagnétique de type relais comportant un circuit magnétique constitué d'une armature magnétique fixe et d'une palette mobile à l'encontre d'un ressort et apte à déplacer un organe mécanique d'actionnement dépassant d'un boîtier via un orifice pratiqué dans celui- ci, un aimant permanent apte à attirer la palette au contact de l'armature, ainsi qu'au moins une bobine d'induction, **caractérisé par** les étapes suivantes :
a/ fermeture et maintien de la palette au contact de l'armature ;
b/ montage d'une ou deux bobines autour de l'armature ;
c/ envoi d'au moins un signal de courant I dans la ou les bobines ;
d/ mesure de la tension U aux bornes de la ou de l'une des bobines;
e/ mesure du courant I dans la ou l'autre des bobines ;
f/ calcul de l'impédance Zcal = U/I ;
g/ détermination du nombre de spires à bobiner en utilisant un abaque de bobinage représentant Nspires = f(Zcal).

2. Procédé de limitation des variations d'impédance d'un actionneur électromagnétique selon la revendication précédente, **caractérisée par** la génération et l'utilisation d'une première abaque représentant Zreel = f1(Zcal) pour un nombre prédéterminé d'actionneurs munis d'une succession de bobines ayant une pluralité prédéterminée de valeurs de nombres de spires, puis par la génération et l'utilisation d'une seconde abaque représentant Nspires = f2(Zreel) pour un nombre prédéterminé d'actionneurs munis d'une succession de bobines ayant une pluralité prédéterminée de valeurs de nombres de spires, et le croisement des deux abaques précédentes pour générer l'abaque de bobinage.

3. Procédé de limitation des variations d'impédance d'un actionneur électromagnétique selon l'une des revendications précédentes, **caractérisé en ce que** la palette est fermée et maintenu en position fermée par action mécanique sur l'organe d'actionnement.

4. Procédé de limitation des variations d'impédance d'un actionneur électromagnétique selon l'une des revendications 1 et 2, **caractérisé en ce que** la palette est fermée et maintenue en position fermée par passage d'un courant continu dans la bobine d'induction.

5. Procédé de limitation des variations d'impédance d'un actionneur électromagnétique selon l'une des revendications précédentes, **caractérisé en ce que** deux bobines, respectivement de n spires et d'une spire sont enroulées autour de l'armature.

6. Procédé de limitation des variations d'impédance d'un actionneur électromagnétique selon l'une des revendications 1 à 4, **caractérisé en ce qu'**une unique bobine de n spires est montée autour de l'armature.

7. Procédé de limitation des variations d'impédance d'un actionneur électromagnétique selon l'une des revendications 5 et 6, **caractérisé en ce que** n est égal à 5.

8. Procédé de limitation des variations d'impédance d'un actionneur électromagnétique selon l'une des revendications précédentes, **caractérisé en ce que** le signal de courant envoyé dans la ou les bobines est d'allure sinusoïdale.

9. Procédé de limitation des variations d'impédance d'un actionneur électromagnétique selon l'une des revendications 1 à 7, **caractérisé en ce que** le signal de courant envoyé dans la ou les bobines est constitué d'une composante continue et d'une composante d'allure sinusoïdale.

10. Procédé de limitation des variations d'impédance d'un actionneur électromagnétique selon l'une des revendications 1 à 7, **caractérisé en ce que** deux signaux de courant sont envoyés dans la ou les bobines, constitués de deux composantes continues distinctes et d'une composante sinusoïdale.

11. Procédé de limitation des variations d'impédance d'un actionneur électromagnétique selon l'une quelconque des revendication précédentes, **caractérisé en ce que**, lorsqu'il y a deux bobines, la mesure de la tension U s'effectue aux bornes de la bobine à n spires et la mesure du courant I s'effectue dans la bobine à une spire.

12. Procédé de limitation des variations d'impédance d'un actionneur électromagnétique selon l'une quelconque des revendications précédentes, l'actionneur comportant un boîtier permettant à la bobine d'induction d'être bobinée hors du boîtier autour d'une branche de l'armature, procédé **caractérisé en ce qu'**il comprend en outre l'étape suivante consistant à refermer ledit boîtier sur tous les composants autres de la branche de l'armature.

13. Procédé de limitation des variations d'impédance d'un actionneur électromagnétique selon l'une quelconque des revendications précédentes, **caractérisé en ce que** l'actionneur est disposé entre des bobines de Helmholtz pendant la réalisation des étapes a/ à g/.

## Patentansprüche

1. Verfahren zur Begrenzung der Impedanzschwankungen eines elektromagnetischen Betätigers des Typs Relais, umfassend eine magnetische Schaltung, die aus einem festen Magnetanker und einem gegen eine Feder beweglichen Anker gebildet und ausgelegt ist, ein mechanisches Betätigungselement, das aus einem Gehäuse durch eine in das Gehäuse eingearbeitete Öffnung hinausragt, zu bewegen, einen Permanentmagneten, der geeignet ist, den beweglichen Anker in Kontakt mit dem Magnetanker zu ziehen und wenigstens eine Induktionsspule,
welches durch die folgenden Schritte gekennzeichnet ist:
a) Schließen und Halten des beweglichen Ankers in Kontakt mit dem Magnetanker;
b) Montage einer oder zweier Spulen um den Magnetanker;
c) Schicken wenigstens eines Stromsignals I in die eine Spule oder in die Spulen;
d) Messen der Spannung U an den Anschlüssen der einen oder der einen der beiden Spulen;
e) Messen des Stroms I in der oder der anderen der Spulen;
f) Berechnen der Impedanz Zcal = U/I;
g) Bestimmen der Anzahl der zu wickelnden Windungen unter Verwendung eines Wicklungsdiagramms, welches N_{Windungen} = f(Zcal) darstellt.

2. Verfahren zur Begrenzung der Impedanzschwankungen eines elektromagnetischen Betätigers nach dem vorhergehenden Anspruch, **gekennzeichnet durch** die Erzeugung und Verwendung eines ersten Diagramms, welches Zreel = f1(Zcal) für eine vorbestimmte Anzahl von Betätigern darstellt, die mit einer Folge von Spulen versehen sind, welche eine vorbestimmte Vielzahl von Windungszahlwerten aufweist, dann **durch** die Erzeugung und Verwendung eines zweiten Diagramms, welches N_{Windung} = f2(Zreel) für eine vorbestimmte Anzahl von Betätigern darstellt, die mit einer Folge von Spulen versehen sind, welche eine vorbestimmten Vielzahl von Windungszahlwerten aufweist und **durch** die Zusammenführung der zwei vorgenannten Diagramme, um das Wicklungsdiagramm zu erzeugen.

3. Verfahren zur Begrenzung der Impedanzschwankungen eines elektromagnetischen Betätigers nach einem der vorhergehenden Ansprüche, **dadurch gekennzeichnet, dass** der bewegliche Anker geschlossen ist und mittels einer mechanischen Einwirkung auf das Betätigungselement in geschlossener Position gehalten wird.

4. Verfahren zur Begrenzung der Impedanzschwankungen eines elektromagnetischen Betätigers nach einem der Ansprüche 1 und 2, **dadurch gekennzeichnet, dass** der bewegliche Anker geschlossen ist und durch Fluss eines Gleichstroms in der Induktionsspule in geschlossener Position gehalten wird.

5. Verfahren zur Begrenzung der Impedanzschwankungen eines elektromagnetischen Betätigers nach einem der vorhergehenden Ansprüche, **dadurch gekennzeichnet, dass** zwei Spulen, die n-Windungen bzw. eine Windung aufweisen, um den Magnetanker gewickelt sind.

6. Verfahren zur Begrenzung der Impedanzschwankungen eines elektromagnetischen Betätigers nach einem der Ansprüche 1 bis 4, **dadurch gekennzeichnet, dass** eine einzige Spule mit n-Windungen um den Magnetanker montiert ist.

7. Verfahren zur Begrenzung der Impedanzschwankungen eines elektromagnetischen Betätigers nach einem der Ansprüche 5 und 6, **dadurch gekennzeichnet, dass** n gleich 5 ist.

8. Verfahren zur Begrenzung der Impedanzschwankungen eines elektromagnetischen Betätigers nach einem der vorhergehenden Ansprüche, **dadurch gekennzeichnet, dass** das in die eine oder die Spulen geschickte Stromsignal einen sinusförmigen Verlauf hat.

9. Verfahren zur Begrenzung der Impedanzschwankungen eines elektromagnetischen Betätigers nach einem der Ansprüche 1 bis 7, **dadurch gekennzeichnet, dass** das in die eine oder die Spulen geschickte Stromsignal aus einer stetigen Komponente und einer sinusförmigen Komponente gebildet ist.

10. Verfahren zur Begrenzung der Impedanzschwankungen eines elektromagnetischen Betätigers nach einem der Ansprüche 1 bis 7, **dadurch gekennzeichnet, dass** zwei Stromsignale in die eine oder die Spulen geschickt werden, wobei die Stromsignale aus zwei unterschiedlichen stetigen Komponenten und einer sinusförmigen Komponente gebildet sind.

11. Verfahren zur Begrenzung der Impedanzschwankungen eines elektromagnetischen Betätigers nach einem der vorhergehenden Ansprüche, **dadurch gekennzeichnet, dass** für den Fall, dass es zwei Spulen gibt, die Messung der Spannung U an den Anschlüssen der Spulen mit n-Wicklungen und die Messung des Stroms I in der Spule mit einer Wicklung durchgeführt werden.

12. Verfahren zur Begrenzung der Impedanzschwankungen eines elektromagnetischen Betätigers nach einem der vorhergehenden Ansprüche, wobei der Betätiger ein Gehäuse aufweist, das es der Induktionsspule ermöglicht, um einen Arm des Magnetankers außerhalb des Gehäuses gewickelt zu werden, wobei das Verfahren **dadurch gekennzeichnet ist, dass** es darüber hinaus den folgenden Schritt umfasst, der darin besteht, das Gehäuse über alle anderen Komponenten außer dem Arm des Magnetankers wieder zu verschließen.

13. Verfahren zur Begrenzung der Impedanzschwankungen eines elektromagnetischen Betätigers nach einem der vorhergehenden Ansprüche, **dadurch gekennzeichnet, dass** der Betätiger während der Umsetzung der Schritte a) bis g) zwischen Helmholtz-Spulen angeordnet ist.

## Claims

1. Method for limiting impedance variations of an electromagnetic actuator such as a relay comprising a magnetic circuit consisting of a fixed magnetic armature and a moving vane placed against a spring and capable of moving a mechanical actuator element projecting from a housing via an opening made in the latter, a permanent magnet suitable for attracting the vane to the contact of the armature, as well as at least one induction coil, **characterised by** the following steps:
a/ closing and maintaining the vane in contact with the armature;
b/ mounting one or two coils around the armature;
c/ sending at least one signal with current I to the coil or coils;
d/ measuring the voltage U at the terminals of the coil or one of the coils; -
e/ measuring the current I in one or other of the coils;
f/ calculating the impedance Zeal = U/I;
g/ determining the number of turns to be coiled using a coil nomogram representing Nturns = f(Zcal).

2. Method for limiting impedance variations of an electromagnetic actuator according to the preceding claim, **characterised by** the generation and use of a first nomogram representing Zreel = fl(Zcal) for a predetermined number of actuators provided with a succession coils having a predetermined plurality of numbers of turns, then by the generation and the use of a second nomogram representing Nturns = f2(Zreel) for a predetermined number of actuators provided with a succession of coils having a predetermined plurality of numbers of turns, and the crossing of the two preceding nomograms for generating the coil nomogram.

3. Method for limiting impedance variations of an electromagnetic actuator according to any one of the preceding claims, **characterised in that** the vane is closed and held in a closed position by mechanical action on the actuating element.

4. Method for limiting impedance variations of an electromagnetic actuator according to any one of claims 1 and 2, **characterised in that** the vane is closed and held in a closed position by passing a continuous current into the induction coil.

5. Method for limiting impedance variations of an electromagnetic actuator according to any one of the preceding claims, **characterised in that** two coils of n turns and one turn respectively are wound around the armature.

6. Method for limiting impedance variations of an electromagnetic actuator according to any one of claims 1 to 4, **characterised in that** a single coil of n turns is mounted around the armature.

7. Method for limiting impedance variations of an electromagnetic actuator according to any one of claims 5 and 6, **characterised in that** n is equal to 5.

8. Method for limiting impedance variations of an electromagnetic actuator according to any one of the preceding claims, **characterised in that** the current signal sent to the coil or coils is sinusoidal.

9. Method for limiting impedance variations of an electromagnetic actuator according to any one of claims 1 to 7, **characterised in that** the current signal sent into the coil or coils is formed by a continuous component and a sinusoidal component.

10. Method for limiting impedance variations of an electromagnetic actuator according to any one of claims 1 to 7, **characterised in that** two current signals are send into the coil or coils, formed by two different continuous components and a sinusoidal component.

11. Method for limiting impedance variations of an electromagnetic actuator according to any one of the preceding claims, **characterised in that** when there are two coils, the measurement of the voltage U is performed at the terminals of the coil with n turns and the measurement of the current I is performed in the coil with one turn.

12. Method for limiting impedance variations of an electromagnetic actuator according to any one of the preceding claims, the actuator comprising a housing enabling the induction coil to be coiled outside of the housing around a branch of the armature, **characterised in that** it also comprises the following step consisting of closing said housing over all of the other components of the branch of the armature.

13. Method for limiting impedance variations of an electromagnetic actuator according to any one of the preceding claims, **characterised in that** the actuator is arranged between the Helmholtz coils during the implementation of steps a/ to g/.
